# FASCICULE DE BREVET EUROPEEN

(11) **EP 2 851 949 B1**
(45) Date de publication et mention de la délivrance du brevet: **06.07.2016**
(21) Numéro de dépôt: 14184988.5
(22) Date de dépôt: 16.09.2014
(51) Int. Cl.: H01L 23/473, H01L 25/065, F28F 27/02, F28D 9/00, H05K 1/02

(54) **Dispositif de refroidissement d'une puce de circuit intégré**
Kühlvorrichtung für Chip mit einem integrierten Schaltkreis
Cooling device for integrated circuit chip

(30) Priorité: 17.09.2013 FR 1358934
(43) Date de publication de la demande: 25.03.2015
(73) Titulaire: COMMISSARIAT A L'ENERGIE ATOMIQUE ET AUX ENERGIES ALTERNATIVES, 75015 Paris (FR); STMicroelectronics (Crolles 2) SAS, 38920 Crolles (FR); STmicroelectronics SA, 92120 Montrouge (FR)
(72) Inventeur: Monfray, Stéphane, 38320 Eybens (FR); Lhostis, Sandrine, 38570 Theys (FR); Maitre, Christophe, 38530 Barraux (FR); Kokshagina, Olga, 75019 Paris (FR); Coronel, Philippe, 38530 Barraux (FR)
(74) Mandataire: Thibon, Laurent

(56) Documents cités:
- JP-A- 2004 295 718
- US-A1- 2004 113 265
- US-A1- 2006 227 512
- US-B1- 7 763 973

## Description

### Domaine

La présente demande concerne un dispositif de refroidissement d'une puce de circuit intégré.

### Exposé de l'art antérieur

Il a déjà été proposé, dans l'article intitulé "3-D Packaging With Through-Silicon Via (TSV) for Electrical and Fluidic Interconnections" de Navas Khan et al., un dispositif de refroidissement d'une puce de circuit intégré comportant un réseau de micro-canalisations dans lequel circule un liquide entraîné par une pompe.

Un autre dispositif de ce type est décrit dans l'article intitulé' "Hybrid 3D-IC Cooling System Using Micro-Fluidic Cooling and Thermal TSVs" de Bing Shi et al.

D'autres exemples de dispositifs de refroidissement de puce de circuit intégré sont décrits dans les documents US2004/113265, US7763973, JP2004295718 et US2006/227512.

Il existe toutefois un besoin pour un dispositif simple, compact, et facile à réaliser, permettant de refroidir efficacement une gamme de puces variées, notamment des puces comportant des zones dissipant, en fonctionnement, des quantités d'énergie thermique différentes.

### Résumé

Ainsi, un mode de réalisation prévoit un dispositif de refroidissement d'une puce de circuit intégré, comportant, un réseau de micro-canalisations dans lequel dés portions de canalisations sont reliées par des vannes comportant chacune au moins une lamelle bicouche, dans lequel le réseau de micro-canalisations comprend un premier réseau de tranchées interconnectées situées dans un premier substrat, et un deuxième réseau de tranchées interconnectées situées dans un deuxième substrat superposé au premier substrat et séparé du premier substrat par un empilement de deux couches de matériaux distincts de coefficients de dilatation thermique différents.

Selon un mode de réalisation, dans chaque vanne, la lamelle est adaptée à changer de forme sous l'effet d'une variation de sa température.

Selon un mode de réalisation, dans chaque vanne, la lamelle est adaptée à passer d'une première forme dans laquelle la lamelle délimite dans la vanne une première ouverture, lorsque sa température est inférieure à un premier seuil, à une deuxième forme dans laquelle la lamelle délimite dans la vanne une deuxième ouverture plus grande que la première ouverture, lorsque sa température atteint le premier seuil.

Selon un mode de réalisation, dans chaque vanne, la lamelle est en outre adaptée à repasser de sa deuxième forme à sa première forme lorsque sa température redescend en dessous d'un deuxième seuil inférieur au premier seuil.

Selon un mode de réalisation, dans chaque vanne, le passage de la lamelle de sa première forme à sa deuxième forme est irréversible.

Selon un mode de réalisation, dans chaque vanne, la lamelle comprend deux couches superposées de matériaux distincts de coefficients de dilatation thermique différents.

Selon un mode de réalisation, le matériau de chacune des couches est choisi dans le groupe comprenant le nitrure de titane, le titane, l'aluminium, le cuivre, le fer, l'or, le tungstène, le platine, un alliage fer-nickel, l'oxyde de silicium, ou un alliage de l'un quelconque de ces matériaux.

Selon un mode de réalisation, dans chaque vanne, la lamelle a une forme en portion de disque.

Selon un mode de réalisation, le réseau de micro-canalisations comprend en outre des premiers et seconds trous traversant le deuxième substrat et reliant le deuxième réseau de tranchées au premier réseau de tranchées.

Selon un mode de réalisation, les premiers trous relient le deuxième réseau de tranchées au premier réseau de tranchées directement.

Selon un mode de réalisation, chaque second trou relie le deuxième réseau de tranchées au premier réseau de tranchées par l'intermédiaire de l'une des vannes, les lamelles étant formées dans ledit empilement.

Selon un mode de réalisation, les trous ont une forme évasée.

Selon un mode de réalisation, les lamelles sont bistables.

Selon un mode de réalisation, les lamelles sont à déformation progressive.

### Brève description des dessins

Ces caractéristiques et avantages, ainsi que d'autres, seront exposés en détail dans, la description suivante de modes de réalisation particuliers faite à titre non limitatif en relation avec les figures jointes parmi lesquelles :
les figures 1A et 1B sont des vues en coupe illustrant un exemple de dispositif de refroidissement d'une puce de circuit intégré ;
les figures 2A à 2D sont des vues en coupe illustrant un exemple d'un mode de réalisation d'un dispositif de refroidissement d'une puce de circuit intégré ;
les figures 3A, 3B1 et 3B2 représentent plus en détail un exemple de réalisation d'une vanne d'un dispositif de refroidissement du type décrit en relation avec les figures 2A à 2D ;
la figure 4 est une vue en coupe illustrant une variante de réalisation d'un dispositif de refroidissement d'une puce de circuit intégré ; et
les figures 5A à 5G sont des vues en coupe illustrant un exemple de procédé de fabrication d'un dispositif de refroidissement d'une puce de circuit intégré.

### Description détaillée

Par souci de clarté, de mêmes éléments ont été désignés par de mêmes références aux différentes figures et, de plus, les diverses figures ne sont pas tracées à l'échelle. Par ailleurs, dans la suite de la description, sauf indication contraire, les termes "approximativement", "sensiblement", " environ " et "de l'ordre de" signifient "à 10 % près", et des références directionnelles telles que surmontant, dessus, dessous, supérieur, inférieur, vertical, horizontal, latéral, etc. s'appliquent à des dispositifs orientés de la façon illustrée dans les vues en coupe latérales des figures correspondantes, étant entendu que, en fonctionnement, les dispositifs peuvent être orientés différemment.

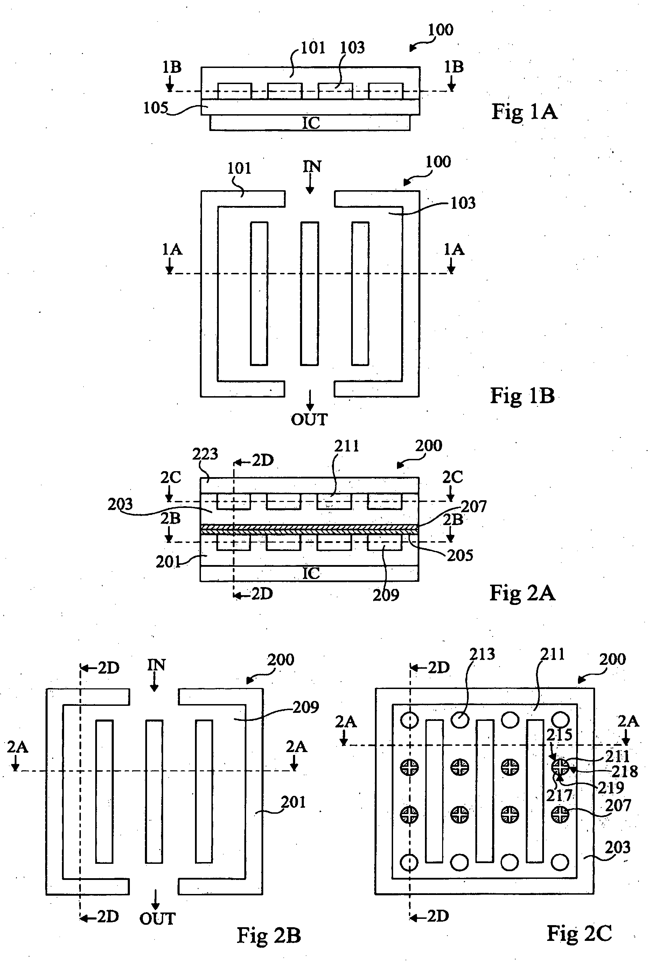

Les figures 1A et 1B sont des vues en coupe illustrant un exemple d'un dispositif 100 de refroidissement d'une puce de circuit intégré IC. La figure 1A est une vue en coupe latérale du dispositif 100 et de la puce IC selon le plan de coupe 1A-1A de la figure 1B, et la figure 1B est une vue en coupe de dessus du dispositif 100 selon le plan de coupe 1B-1B de la figure 1A.

Le dispositif 100 comprend un substrat 101, par exemple en silicium, en oxyde de silicium ou en nitrure d'aluminium. Le substrat 101 a par exemple une épaisseur de quelques micromètres à quelques millimètres. Du côté de sa face inférieure, le substrat 101 comprend un réseau de tranchées 103 interconnectées régulièrement réparties sur la surface du substrat. Les tranchées 103 s'étendent dans le substrat 101 sur une profondeur inférieure à l'épaisseur du substrat. A titre d'exemple, les tranchées 103 ont une profondeur de l'ordre de 1 à 500 µm, et s'étendent longitudinalement sur des distances de l'ordre de 1 à 100 mm. Du côté de la face inférieure du substrat 101, le dispositif 100 comprend en outre un capot 105, par exemple une plaque approximativement plane accolée à la face inférieure du substrat 101, qui ferme hermétiquement chacune des tranchées 103 du côté de sa face inférieure. Le capot 105 est par exemple en silicium, en métal (par exemple en cuivre), en verre ou en plastique (par exemple en PMMA - Polyméthacrylate de méthyle). L'épaisseur du capot 105 peut être comprise entre quelques micromètres et quelques millimètres. Les parois des tranchées 103 et le capot 105 définissent un réseau de micro-canalisations interconnectées dans lequel peut circuler un liquide de refroidissement. Dans cet exemple, le réseau de micro-canalisations du dispositif 100 comprend une ouverture d'entrée IN par laquelle du liquide de refroidissement peut entrer dans le réseau, et une ouverture de sortie OUT par laquelle du liquide de refroidissement peut sortir du réseau. Le dispositif 100 peut comporter une pompe, non représentée, pour assurer la circulation du liquide de refroidissement de l'entrée IN vers la sortie OUT du réseau de micro-canalisations. Dans l'exemple représenté, la puce IC (figure 1A) à refroidir est accolée à la face inférieure du capot 105.

Dans cet exemple, la quantité d'énergie thermique qui peut être évacuée par le dispositif 100 est sensiblement la même en tout point de la surface à refroidir. Toutefois, dans la pratique, des régions distinctes d'une même puce de circuit intégré peuvent, en fonctionnement, dissiper des quantités d'énergie thermique différentes. Dans ce cas, le refroidissement procuré par le dispositif 100 n'est pas optimal. En effet, lorsque le dispositif de refroidissement 100 est dimensionné pour permettre de refroidir suffisamment les zones les plus chaudes de la puce, les zones les moins chaudes de la puce sont refroidies plus que nécessaire. Il en résulte notamment une consommation électrique superflue de la pompe assurant la circulation du liquide de refroidissement dans le dispositif.

Pour améliorer l'efficacité du refroidissement lorsque la puce à refroidir comporte des zones dissipant des quantités d'énergie thermique différentes, on pourrait jouer sur la répartition des micro-canalisations en regard de la surface à refroidir. On pourrait par exemple prévoir une densité de micro-canalisations en regard des zones les plus chaudes de la puce supérieure à la densité de micro-canalisations en regard des zones les moins chaudes de la puce.

Toutefois, cette solution nécessite de connaître à l'avance, lors de la conception du dispositif de refroidissement, le comportement thermique de la puce, et notamment la position des points chauds de la puce. Le dispositif de refroidissement est alors spécifique à un type de puce particulier, ce qui n'est pas économique. De plus, un tel dispositif de refroidissement perd son efficacité si des points chauds de la puce se déplacent en cours de fonctionnement, ce qui peut arriver dans certains types de puces.

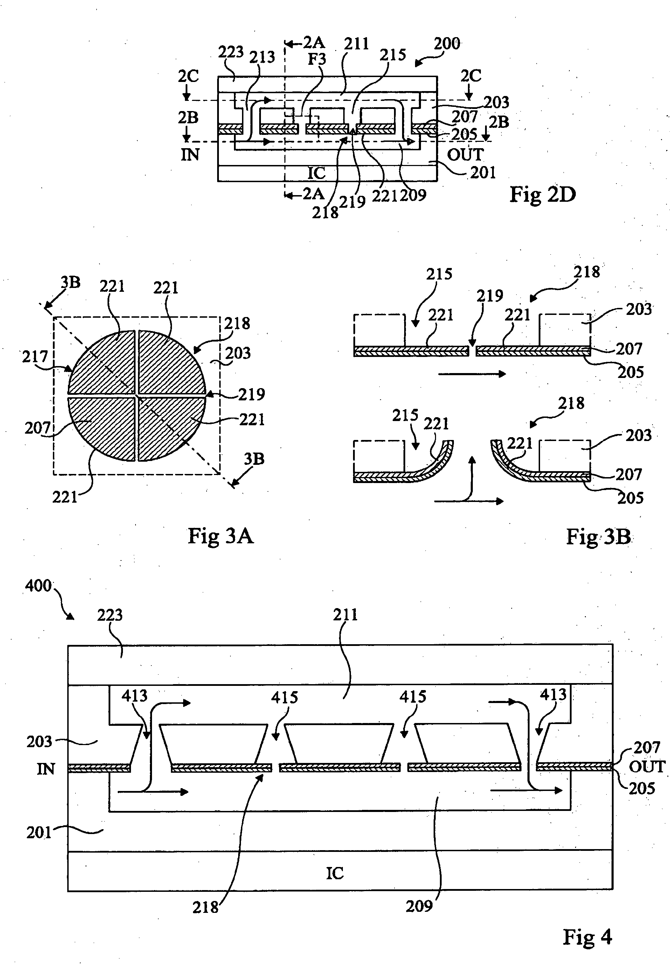

Les figures 2A à 2D sont des vues en coupe illustrant un exemple d'un mode de réalisation d'un dispositif 200 de refroidissement d'une puce de circuit intégré IC. La figure 2A est une vue en coupe latérale du dispositif 200 et de la puce IC selon le plan de coupe 2A-2A des figures 2B, 2C et 2D, la figure 2B est une vue en coupe de dessus du dispositif 200 selon le plan de coupe 2B-2B des figures 2A et 2D, la figure 2C est une vue en coupe de dessus du dispositif 200 selon le plan de coupe 2C-2C des figures 2A et 2D, et la figure 2D est une vue en coupe latérale du dispositif 200 et de la puce IC selon le plan de coupe 2D-2D des figures 2A, 2B et 2C.

Le dispositif 200 comprend, dans cet exemple, deux substrats 201 et 203 superposés, séparés par un empilement de deux couches 205, 207 de matériaux distincts, par exemple des métaux, ayant des coefficients de dilatation thermique différents. Le matériau de chacune des couches 205, 207 est par exemple choisi parmi le nitrure de titane, le titane, l'aluminium, le cuivre, le fer, l'or, le tungstène, le platine, un alliage fer-nickel, l'oxyde de silicium, ou un alliage de l'un quelconque de ces matériaux. Chacune des deux couches 205, 207 a par exemple une épaisseur d'environ 0,1 à 10 µm. Les substrats 201 et 203 sont par exemple en silicium ou en oxyde de silicium, mais les modes de réalisation décrits ne se limitent pas à ces exemples particuliers. Plus généralement, les substrats 201 et 203 peuvent être en tout matériau semiconducteur, conducteur ou isolant dans lequel des tranchées peuvent être formées. Dans l'exemple représenté, le substrat 203 est situé au dessus du substrat 201.

Du côté de sa face tournée vers les couches 205, 207, c'est-à-dire du côté de sa face supérieure dans l'orientation des figures 2A et 2D, le substrat 201 comprend un réseau de tranchées 209 interconnectées, par exemple régulièrement réparties sur la surface du substrat. Les tranchées 209 s'étendent dans le substrat 201, depuis sa face supérieure, sur une profondeur inférieure à l'épaisseur totale du substrat 201.

Du côté de sa face opposée aux couches 205, 207, c'est-à-dire du côté de sa face supérieure dans l'orientation des figures 2A et 2D, le substrat 203 comprend un réseau de tranchées 211 interconnectées, par exemple régulièrement réparties sur la surface du. substrat. Les tranchées 211 s'étendent dans le substrat 203, depuis sa face supérieure, sur une profondeur inférieure à l'épaisseur totale du substrat 203.

Les tranchées 209 et 211 sont par exemple disposées de façon qu'au moins une portion du réseau de tranchées 209 soit en regard d'une portion du réseau de tranchées 211, c'est-à-dire soit alignée, en projection verticale dans l'orientation des figures 2A et 2D, avec une portion du réseau de tranchées 211. Dans l'exemple représenté, toutes les tranchées 209 formées dans le substrat 201 sont en regard de tranchées 211 formées dans le substrat 203 et vice et versa. Les modes de réalisation décrits ne se limitent toutefois pas à ce cas particulier.

Dans le dispositif 200, des trous s'étendent dans le substrat 203 depuis le fond de tranchées 211, traversant entièrement la partie inférieure du substrat 203, et débouchant du côté du substrat 203 tourné vers les couches 205, 207, en regard de tranchées 209. Certains de ces trous, référencés 213 sur les figures 2C et 2D, traversent l'empilement des couches 205, 207, et débouchent dans le réseau de tranchées 209. D'autres trous, référencés 215 sur les figures 2C et 2D, débouchent sur l'empilement des couches 205, 207, mais ne traversent pas les couches 205 et 207. Les trous 213, 215 s'étendent par exemple approximativement verticalement dans le substrat 203.

Au fond de chaque trou 215, la portion 217 de l'empilement des couches 205, 207 située en regard du trou comprend au moins une ouverture traversante 219 en forme de fente relativement étroite, par exemple de largeur comprise entre 20 nm et 1 µm, délimitant dans la portion 217 au moins une lamelle bicouche 221, par exemple une lamelle bimétallique. Dans cet exemple, comme cela sera expliqué plus en détail ci-après en relation avec les figures 3A, 3B1 et 3B2, chaque lamelle 221 est initialement sensiblement plane à température ambiante, et est adaptée à se déformer en s'incurvant lorsque sa température dépasse un seuil T1 supérieur à la température ambiante, du fait de la différence de coefficient de dilatation thermique qui existe entre la couche 205 et la couche 207.

Du côté de la face du substrat 203 opposée aux couches 205, 207, c'est-à-dire du côté de la face supérieure du substrat 203 dans l'orientation des figures 2A et 2D, le dispositif 200 comprend en outre un capot 223, par exemple une plaque approximativement plane accolée à la face supérieure du substrat 203, qui ferme hermétiquement chacune des tranchées 211 du côté de sa face supérieure. Le capot 223 peut être un substrat en silicium, en verre, en métal, en plastique, ou en tout autre matériau isolant, semiconducteur ou conducteur adapté à fermer hermétiquement les tranchées. A titre d'exemple, le matériau du capot 223 est en un polymère, par exemple du polyéthylène, du PVC, etc.

Les parois des tranchées 209 et 211, les parois des trous traversants 213 et 215, et le capot 223, définissent un réseau de micro-canalisations interconnectées dans lequel peut circuler un fluide de refroidissement sous forme liquide ou gazeuse, par exemple de l'eau, un alcool tel que l'alcool isopropylique, un métal liquide tel que le gallium, un liquide spécifique tel que le liquide commercialisé par la société 3M sous la dénomination "Novec 7500 Engineered Fluid". Plus généralement, d'autres types de fluide de refroidissement peuvent être envisagés, par exemple un mélange de liquides miscibles ou non, un fluide en équilibre entre ses phases liquide, gazeuse et/ou solide (gel) adapté à évacuer de la chaleur par changement de phase (fonctionnement de type caloduc), etc. A titre d'exemple, les micro-canalisations ont, en section transversale, des dimensions comprises entre 1 et 1000 µm. Ainsi, dans le dispositif 200, les trous traversants 213, 215 sont par exemple des trous cylindriques à section approximativement circulaire de diamètre compris entre 1 et 1000 µm, et les tranchées 209, 211 ont par exemple une section approximativement carrée ou rectangulaire dont les dimensions des côtés sont comprises entre 1 et 1000 µm.

Dans cet exemple, le réseau de micro-canalisations du dispositif 200 comprend une ouverture d'entrée IN par laquelle du fluide de refroidissement peut entrer dans le réseau, et une ouverture de sortie OUT par laquelle du fluide de refroidissement peut sortir du réseau. Le dispositif 200 peut comporter une pompe, non représentée, pour assurer la circulation du fluide de refroidissement de l'entrée IN vers la sortie OUT du réseau de micro-canalisations. Dans l'exemple représenté, la puce IC (figures 2A et 2D) à refroidir est accolée à la face inférieure du substrat 201.

Dans le dispositif 200, chaque portion 217 de l'empilement de couches 205, 207 située en regard d'un trou 215 définit une vanne 218 reliant deux portions de canalisation du réseau. L'ouverture de chaque vanne 218 dépend de la forme de la ou des lamelles 221 qu'elle comprend. Chaque vanne 218 peut avoir au moins deux états : un premier état, que l'on appellera ici l'état fermé, dans lequel la ou les lamelles 221 de la vanne ont des formes telles qu'elles ferment presque totalement l'ouverture entre les deux portions de canalisation reliées par la vanne, ne permettant le passage que d'une quantité de fluide négligeable ou nulle à travers la vanne ; et un deuxième état, que l'on appellera ici l'état ouvert, dans lequel la ou les lamelles 221 de la vanne ont des formes telles qu'elles délimitent une ouverture apte à laisser passer une quantité de fluide non négligeable à travers la vanne. Des vannes 218 peuvent être régulièrement réparties dans le réseau de micro-canalisations du dispositif.

Les figures 3A, 3B1 et 3B2 représentent plus en détail un exemple de réalisation d'une vanne 218 du dispositif de refroidissement 200 des figures 2A à 2D. Plus particulièrement, les figures 3A, 3B1 et 3B2 sont des vues agrandies d'une portion F3 du dispositif 200 représentée en traits pointillés en figure 2D et comportant une vanne 218. La figure 3A est une vue de dessus de la vanne 218 à l'état fermé, et les figures 3B1 et 3B2 comprennent deux vues en coupe de la vanne 218 selon le plan de coupe 3B-3B de la figure 3A, représentant la vanne 218 respectivement à l'état fermé et à l'état ouvert.

A l'état fermé (figure 3B1), la vanne 218 comprend, dans cet exemple, quatre lamelles 221 approximativement planes. Chaque lamelle 221 correspond approximativement à un quart du disque formé par la portion 217 de l'empilement 205, 207 situé au fond du trou 215 dans lequel se situe la vanne. Les quatre lamelles 221 sont délimitées dans la portion d'empilement 217 par une ouverture traversante 219 en forme de fente cruciforme dont le centre coïncide sensiblement avec le centre de la portion d'empilement 217.

Sous l'effet d'un échauffement, du fait de la différence de coefficient de dilatation thermique entre les matériaux des couches 205 et 207, les lamelles 221 sont susceptibles de prendre une forme incurvée, telle que représentée en figure 3B2, définissant à travers la vanne 218 une ouverture plus importante que l'ouverture 219 séparant les lamelles 221 à l'état fermé. La vanne 218 est alors à l'état ouvert. Dans l'exemple représenté, lorsque la vanne 218 est à l'état ouvert, chaque lamelle 221 a une forme incurvée telle que son extrémité libre, à savoir la pointe de la lamelle orientée vers lé centre de la vanne, se situe au dessus de la partie fixe de la lamelle, à savoir le bord arrondi du quart de disque de la lamelle par lequel la lamelle est reliée au reste de l'empilement 205, 207. L'extrémité libre de chaque lamelle 221 est alors plus éloignée du centre de la vanne 218 qu'à l'état fermé. En d'autres termes, dans cet exemple, lorsque la vanne 218 passe de l'état fermé à l'état ouvert, les lamelles 221 s'ouvrent à la façon de pétales de fleur.

Le fonctionnement du dispositif de refroidissement 200 est le suivant.

Dans un état initial dans lequel la puce IC à refroidir n'est pas alimentée et ne dégage pas ou peu d'énergie thermique, toutes les vannes 218 du dispositif sont par exemple à l'état fermé. Du fluide de refroidissement peut circuler entre l'entrée IN et la sortie OUT du réseau de micro-canalisations, en passant dans les canalisations définies par les tranchées 209 et 211 et par les trous 213. Toutefois, le fluide ne traverse pas, ou seulement en quantité négligeable, les vannes 218, et ne circule donc pas ou peu dans les canalisations définies par les trous 215.

Lorsque la puce IC fonctionne, elle dégage de l'énergie thermique, qui est partiellement évacuée par le fluide de refroidissement. L'énergie thermique dégagée par la puce chauffe les vannes 218 du dispositif 200. La quantité d'énergie thermique dégagée par la puce peut être plus importante dans certaines zones de la puce que dans d'autres. Ainsi, les différentes vannes 218 du dispositif peuvent avoir des températures différentes.

Lorsque la température d'une vanne 218 atteint le seuil T1, cette vanne passe à l'état ouvert. Du fluide de refroidissement peut alors circuler dans la portion de canalisation définie par le trou 215 situé au dessus de la vanne. Il en résulte qu'une plus grande quantité de fluide de refroidissement réchauffé par la puce peut être évacuée par le réseau de micro-canalisations dans la zone correspondante. En d'autres termes, l'ouverture de la vanne 218 augmente localement la capacité de refroidissement du dispositif 200 par rapport aux zones du dispositif dans lesquelles les vannes 218 sont à l'état fermé.

Les lamelles 221 des vannes 218 sont par exemple réalisées de façon que le seuil T1 d'ouverture des vannes soit tel que, en régime établi dans des conditions normales de fonctionnement, les vannes 218 situées au dessus de zones chaudes devra puce soient à l'état ouvert, et les vannes 218 situées au dessus de zones moins chaudes de la puce soient à l'état fermé (dans le cas d'une puce comportant des zones dissipant des quantités d'énergie thermique différentes). A titre d'exemple, le seuil T1 peut être compris entre 70 et 90°C.

Dans un premier mode de réalisation, la déformation des lamelles 221 est réversible, c'est-à-dire que lorsque la température d'une vanne 218 à l'état ouvert redescend en dessous d'un seuil T2 inférieur au seuil T1, cette vanne repasse à l'état fermé. Ce premier mode de réalisation trouve un intérêt tout particulier lorsque les points chauds de la puce sont susceptibles de se déplacer pendant le fonctionnement de la puce. En effet, dans ce cas, la capacité locale de refroidissement des différentes zones du dispositif 200 peut s'ajuster automatiquement en fonction des mouvements des zones chaudes de la puce. Le seuil T2 est par exemple compris entre 30 et 70°C. Dans ce premier mode de réalisation, les couches 205 et 207 sont par exemple respectivement en titane et en or, en aluminium et en oxyde de silicium, en titane et en aluminium, en tungstène et en aluminium, ou en tungstène et en or.

Dans un second mode de réalisation, la déformation des lamelles 221 est irréversible, c'est-à-dire qu'une fois qu'une vanne 218 a été ouverte, cette dernière ne se referme pas lorsque sa température redescend. Ce mode de réalisation est notamment adapté au refroidissement de puces dans lesquelles les points chauds ne se déplacent pas pendant le fonctionnement de la puce. Dans ce second mode de réalisation, le réseau de canalisations du dispositif de refroidissement peut être automatiquement configuré lors de la première utilisation de la puce, mais n'est pas reconfiguré à chaque arrêt/redémarrage de la puce. Un avantage est que chaque lamelle 221 du dispositif est actionnée une seule fois au plus, ce qui limite les risques d'usure mécanique. Dans ce deuxième mode de réalisation, les couches 205 et 207 sont par exemple en titane et en cuivre, en tungstène et en cuivre ou en oxyde de silicium et en cuivre.

Les lamelles bicouches 221 peuvent être bistables, c'est-à-dire qu'elles basculent rapidement de l'état fermé à l'état ouvert lorsqu'elles sont chauffées au seuil T1, et, le cas échéant, rebasculent rapidement de l'état ouvert à l'état fermé lorsqu'elles sont refroidies au seuil T2 (dans le premier mode de réalisation).

A titre de variante, les déformations des lamelles 221 peuvent être progressives. Dans ce cas, chaque vanne 218 peut prendre une pluralité d'états intermédiaires entre l'état fermé et l'état ouvert, en fonction de la température des lamelles 221.

La figure 4 est une vue en coupe latérale, dans un plan de coupe similaire au plan de coupe de la figure 2D, illustrant une variante de réalisation d'un dispositif de refroidissement d'une puce de circuit intégré.

Le dispositif 400 de la figure 4 comprend de nombreux éléments communs avec le dispositif 200 des figures 2A à 2D. Dans la suite, seules les différences entre ces deux dispositifs seront mises en exergue.

La principale différence entre le dispositif 400 et le dispositif 200 est que, là où le dispositif 200 comprend des trous traversants 213 et 215 en forme de cylindres rectilignes à section approximativement constante sur toute leur hauteur, le dispositif 400 comprend des trous traversants 413 et 415 de forme différente. Dans l'exemple représenté, les trous 413 traversent l'empilement des couches 205, 207, reliant directement des portions de tranchées 211 à des portions de tranchées 209, et les trous 415 débouchent sur l'empilement de couches 205, 207 sans le traverser. Des vannes 218 situées au fond des trous 415 relient des portions de tranchées 211 à des portions de tranchées 209.

Dans la variante de réalisation de la figure 4, les trous 413, 415 ont une forme adaptée à favoriser le passage du fluide de refroidissement dans un sens plutôt que dans l'autre. Dans l'exemple représenté, les trous 413, 415 ont une forme évasée, par exemple une forme tronconique à section circulaire. Dans cet exemple, l'entrée IN et la sortie OUT du dispositif 400 sont situées dans la partie inférieure du réseau de micro-canalisations, c'est-à-dire dans le niveau de tranchées 209. Au voisinage de son entrée IN, le dispositif 400 comprend, dans cet exemple, un ou plusieurs trous 413 évasés dont la plus grande section est côté tranchées 209 et dont la plus petite section est côté tranchées 211. Ces trous favorisent le passage du fluide de refroidissement du réseau de tranchées 209 vers le réseau de tranchées 211 au voisinage de l'entrée du dispositif. Au voisinage de sa sortie OUT, le dispositif 400 comprend, dans cet exemple, un ou plusieurs trous 413 évasés dont la plus grande section est côté tranchées 211 et dont la plus petite section est côté tranchées 209. Ces trous favorisent le passage du fluide de refroidissement du réseau de tranchées 211 vers le réseau de tranchées 209 au voisinage de la sortie du dispositif. La prévision des trous 413 évasés susmentionnés facilite la distribution du fluide de refroidissement dans tout le réseau de micro-canalisations et sa circulation dans le sens allant de l'entrée IN vers la sortie OUT du dispositif. Par ailleurs, dans cet exemple, les trous 415 sont des trous évasés dont la plus grande section est côté tranchées 209 et dont la plus petite section est côté tranchées 211. Ces trous 415 favorisent le passage du fluide de refroidissement du réseau de tranchées 209 vers le réseau de tranchées 211 lorsque les vannes 218 correspondantes sont à l'état ouvert. A titre de variante, certains des trous 415 ou tous les trous 415 peuvent avoir leur plus grande section côté tranchées 211 et leur plus petite section côté tranchées 209 en fonction du trajet que l'on souhaite faire parcourir au fluide de refroidissement. On notera que les modes de réalisation décrits ne se limitent pas aux formes susmentionnées des trous 413, 415. Plus généralement, l'homme de l'art saura prévoir d'autres formes permettant d'obtenir l'effet recherché. Par ailleurs, un revêtement, non représenté, adapté à faciliter la circulation du fluide de refroidissement, peut optionnellement revêtir les parois de tranchées ou de trous du réseau de microcanalisations.

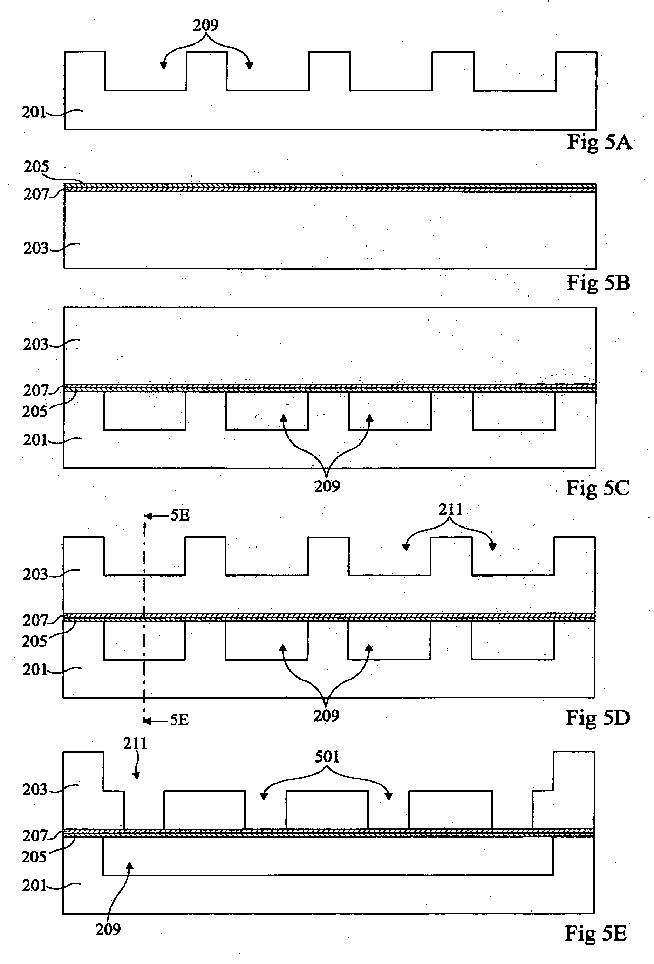

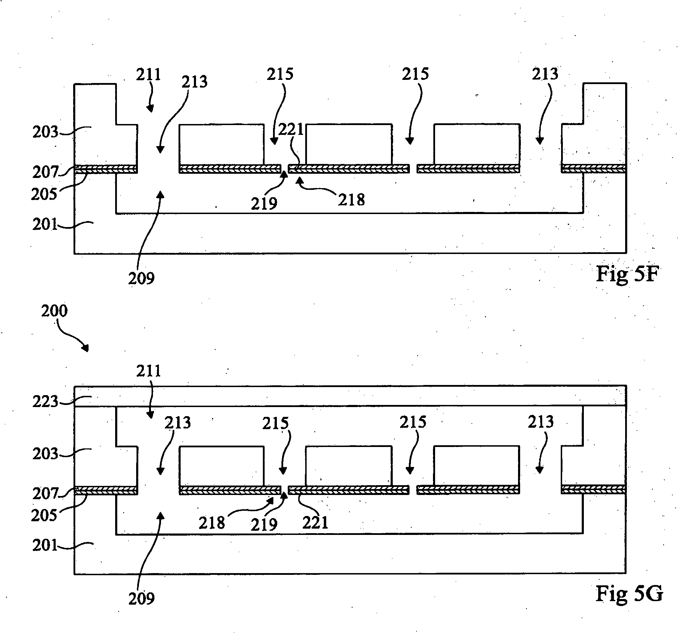

Les figures 5A à 5G sont des vues en coupe latérales illustrant schématiquement des étapes d'un exemple de procédé de fabrication d'un dispositif de refroidissement du type décrit en relation avec les figures 2A à 2D et 3A, 3B. Les figures 5A, 5B, 5C et 5D sont des vues dans un plan de coupe similaire ou identique à celui de la figure 2A, et les figures 5E, 5F et 5G sont des vues dans un plan de coupe similaire ou identique à celui de la figure 2D.

La figure 5A illustre une étape de formation du réseau de tranchées 209 du côté d'une face du substrat 201. Les tranchées 209 sont par exemple formées par gravure, ou par tout autre procédé adapté. Un masque non représenté peut être utilisé pour délimiter les régions du substrat 201 à graver.

La figure 5B illustre une étape de formation, sur une face d'un deuxième substrat 203, des couches empilées 205 et 207. Dans l'exemple représenté, la couche 207 recouvre une face du substrat 203 et la couche 205 recouvre la face de la couche 207 opposée au substrat 203. Les couches 207 et 205 sont par exemple successivement formées par dépôt en phase vapeur, ou par tout autre procédé adapté.

La figure 5C illustre une étape au cours de laquelle le substrat 203 est rapporté sur le substrat 201 et accolé à ce dernier, de façon que la face du substrat 201 côté tranchées 209 soit accolée à la face extérieure de la couche 205.

La figure 5D illustre une étape de formation du réseau de tranchées 211 du côté de la face du substrat 203 opposée aux couches 205, 207. Les tranchées 211 sont par exemple formées par gravure, ou par tout autre procédé adapté. Un masque non représenté peut être utilisé pour délimiter les régions du substrat 203 à graver.

La figure 5E illustre une étape de formation d'une pluralité de trous 501, par exemple régulièrement répartis sur toute la surface du substrat 203, ces trous s'étendant depuis le fond de tranchées 211, traversant la partie inférieure du substrat 203, et débouchant sur la couche 207 sans la traverser. Les trous 501 sont par exemple formés par gravure, ou par tout autre procédé adapté. Des masques, non représentés, peuvent être utilisés pour délimiter les régions du substrat 203 à graver. On notera que la figure 5E est une vue en coupe selon le plan 5E-5E de la figure 5D.

La figure 5F illustre une étape au cours de laquelle certains des trous 501 sont prolongés à travers l'empilement des couches 205, 207 de façon à éliminer entièrement la portion d'empilement 205, 207 située au fond de ces trous et à former les trous 213 du dispositif 200 (figures 2C et 2D). La figure 5F illustre de plus une étape au cours de laquelle, au fond d'autres trous 501, correspondant aux trous 215 du dispositif 200, des ouvertures traversantes 219 sont formées dans l'empilement des couches 205, 207, de façon à délimiter des lamelles bimétalliques 221 de vannes 218. Les étapes d'ouverture complète des trous 213 et de réalisation d'ouvertures traversantes 219 au fond des trous 215 peuvent être réalisées simultanément ou successivement. Les ouvertures dans l'empilement 205, 207 peuvent par exemple être réalisées par gravure. Un masque conforme ou non-conforme, non représenté, peut être formé à la surface du dispositif pour délimiter les zones de l'empilement 205, 207 à retirer lors de la gravure. A titre de variante, les ouvertures dans l'empilement 205, 207 peuvent être formées sans utiliser de masque, par exemple par gravure laser.

La figure 5G illustre une étape de report du capot 223 du côté de la face supérieure du substrat 203. Le capot 223 est par exemple collé sur la face supérieure du substrat 223, par exemple au moyen d'une colle polymère telle qu'une colle à base de benzocyclobutène (BCB).

Les figures 5F et 5G sont aussi des vues en coupe selon le plan 5E-5E de la figure 5D.

Un avantage des modes de réalisation décrits est qu'ils permettent, par rapport aux dispositifs de refroidissement existants, d'améliorer l'efficacité du refroidissement, tout en restant compatible avec des gammes de puces variées dans la mesure où, dans les modes de réalisation décrits, le réseau de micro-canalisations du dispositif de refroidissement est automatiquement configuré en fonction du comportement thermique de la puce.

Des modes de réalisation particuliers ont été décrits. Diverses variantes et modifications apparaîtront à l'homme de l'art.

En particulier, les modes de réalisation décrits ne se limitent pas à l'exemple particulier de forme et d'agencement des lamelles bicouches 221 des vannes 218 décrit en relation avec les figures 3A et 3B. Plus généralement, l'homme de l'art saura obtenir le comportement recherché en utilisant des lamelles bicouches ayant d'autres formes que celles décrites ci-dessus et/ou agencées différemment. A titre d'exemple, les lamelles bicouches peuvent avoir des formes rectangulaires, triangulaires, en portion de disque d'angle inférieur ou supérieur à 45 degrés, etc. En outre, chaque vanne 218 peut comporter un nombre de lamelles différent de 4.

De plus, les modes de réalisation décrits ne se limitent pas à l'exemple susmentionné d'agencement du réseau de micro-canalisations. Les modes de réalisation décrits sont compatibles avec d'autres agencements du réseau de micro-canalisations, par exemple un agencement comportant un nombre de niveaux de tranchées supérieur ou inférieur à deux, dans la mesure où le réseau comprend des vannes à lamelles bicouches dont l'ouverture est susceptible de modifier loyalement la capacité de refroidissement du dispositif. A titre d'exemple, le réseau de micro-canalisations peut comporter plus d'une entrée et plus d'une sortie. En outre, sur la base des principes de fonctionnement énoncés ci-dessus, on peut prévoir un dispositif de refroidissement dans lequel des micro-canalisations transportant un fluide de refroidissement sont prévues des deux côtés de la puce à refroidir.

Par ailleurs, à titre, de variante, les composants électroniques à refroidir ne sont pas nécessairement situés dans une puce distincte du dispositif de refroidissement, mais peuvent être formés dans le substrat 201 ou dans le capot 223 du dispositif de refroidissement.

En outre, les modes de réalisation décrits ne se limitent pas aux exemples susmentionnés de dimensions et de matériaux.

## Revendications

1. Dispositif (200 ; 400) de refroidissement d'une puce (IC) de circuit intégré, comportant un réseau de micro-canalisations (209, 211, 213, 215 ; 209, 211, 413, 415) dans lequel des portions de canalisations sont reliées par des vannes (218) comportant chacune au moins une lamelle (221) bicouche,
**caractérisé en ce que** ledit réseau de micro-canalisations comprend un premier réseau de tranchées (209) interconnectées situées dans un premier substrat (201), et un deuxième réseau de tranchées (211) interconnectées situées dans un deuxième substrat (203) superposé au premier substrat (201) et séparé du premier substrat (201) par un empilement de deux couches (205, 207) de matériaux distincts de coefficients de dilatation thermique différents.

2. Dispositif (200 ; 400) selon la revendication 1, dans lequel, dans chaque vanne (218), ladite au moins une lamelle (221) est adaptée à changer de forme sous l'effet d'une variation de sa température.

3. Dispositif (200 ; 400) selon la revendication 1 ou 2, dans lequel, dans chaque vanne (218), ladite au moins une lamelle (221) est adaptée à passer d'une première forme dans laquelle la lamelle (221) délimite dans la vanne (218) une première ouverture (219), lorsque sa température est inférieure à un premier seuil (T1), à une deuxième forme dans laquelle la lamelle (221) délimite dans la vanne (218) une deuxième ouverture plus grande que la première ouverture, lorsque sa température atteint le premier seuil (T1).

4. Dispositif (200 ; 400) selon la revendication 3, dans lequel, dans chaque vanne (218), ladite au moins une lamelle (221) est en outre adaptée à repasser de sa deuxième forme à sa première forme lorsque sa température redescend en dessous d'un deuxième seuil (T2) inférieur au premier seuil (T1).

5. Dispositif (200 ; 400) selon la revendication 3, dans lequel, dans chaque vanne (218), le passage de ladite au moins une lamelle (221) de sa première forme à sa deuxième forme est irréversible.

6. Dispositif (200 ; 400) selon l'une quelconque des revendications 1 à 5, dans lequel, dans chaque vanne (218), ladite au moins une lamelle (221) comprend deux couches (205, 207) superposées de matériaux distincts de coefficients de dilatation thermique différents.

7. Dispositif (200 ; 400) selon la revendication 6, dans lequel le matériau de chacune desdites couches (205, 207) est choisi dans le groupe comprenant le nitrure de titane, le titane, l'aluminium, le cuivre, le fer, l'or, le tungstène, le platine, un alliage fer-nickel, l'oxyde de silicium, ou un alliage de l'un quelconque de ces matériaux.

8. Dispositif (200 ; 400) selon l'une quelconque des revendications 1 à 7, dans lequel, dans chaque vanne (218), ladite au moins une lamelle (221) a une forme en portion de disque.

9. Dispositif (200 ; 400) selon l'une quelconque des revendications 1 à 8, dans lequel ledit réseau de micro-canalisations comprend en outre des premiers (213 ; 413) et seconds (215 ; 415) trous traversant le deuxième substrat (203) et reliant le deuxième réseau de tranchées (211) au premier réseau de tranchées (209).

10. Dispositif (200 ; 400) selon la revendication 9, dans lequel les premiers trous (213 ; 413) relient le deuxième réseau de tranchées (211) au premier réseau de tranchées (209) directement.

11. Dispositif (200 ; 400) selon la revendication 9 ou 10, dans lequel chaque second trou (215 ; 415) relie le deuxième réseau de tranchées (211) au premier réseau de tranchées (209) par l'intermédiaire de l'une desdites vannes (218), les lamelles (221) étant formées dans ledit empilement (205, 207).

12. Dispositif (400) selon l'une quelconque des revendications 9 à 11, dans lequel lesdits trous (413, 415) ont une forme évasée.

13. Dispositif (200 ; 400) selon l'une quelconque des revendications 1 à 12, dans lequel lesdites lamelles (221) sont bistables.

14. Dispositif (200 ; 400) selon l'une quelconque des revendications 1 à 12, dans lequel lesdites lamelles (221) sont à déformation progressive.

## Patentansprüche

1. Vorrichtung (200; 400) zum Kühlen eines integrierten Schaltungschips (IC), die ein Netzwerk von Mikrorohren (209, 211, 213, 215; 209, 211, 413, 415) aufweist, wobei die Rohrteile durch Ventile (218) verbunden sind, wobei jedes einen Doppelschichtstreifen (221) aufweist,
**dadurch gekennzeichnet dass** das Mikrorohrnetzwerk ein erstes Netzwerk von verbunden Vertiefungen (209) aufweist, die in einem ersten Substrat (201) angeordnet sind, und ein zweites Netzwerk von verbundenen Vertiefungen (211), die in einem zweiten Substrat (203) angeordnet sind, das auf das erste Substrat (201) gestapelt ist und von dem ersten Substrat (201) durch einen Stapel von zwei Schichten (205, 207) von unterschiedlichen Materialien mit unterschiedlichen thermischen Ausdehnungskoeffizienten getrennt ist.

2. Vorrichtung (200; 400) nach Anspruch 1, wobei in jedem Ventil (218) der mindestens eine Streifen (221) ausgebildet ist, um unter dem Effekt einer Veränderung seiner Temperatur seine Form zu ändern.

3. Vorrichtung (200; 400) nach Anspruch 1 oder 2, wobei in jedem Ventil (218) der mindestens eine Streifen (221) ausgebildet ist, um von einer ersten Form, in der der Streifen (221) eine erste Öffnung (219) in dem Ventil (218) begrenzt bzw. drosselt, wenn seine Temperatur niedriger als eine erste Schwelle (T1) ist, zu einer zweiten Form übergeht, in der der Streifen (221) eine zweite Öffnung, die größer ist als die erste Öffnung, in dem Ventil (218) begrenzt bzw. drosselt, wenn seine Temperatur die erste Schwelle (T1) erreicht.

4. Vorrichtung (200; 400) nach Anspruch 3, wobei in jedem Ventil (218) der mindestens eine Streifen (221) weiter ausgebildet ist, um aus seiner zweiten Form in seine erste Form zurückzukehren, wenn seine Temperatur unter eine zweite Schwelle (T2) abfällt, die niedriger ist als die erste Schwelle (T1).

5. Vorrichtung (200; 400) nach Anspruch 3, wobei in jedem Ventil (218) das Übergehen des mindestens einen Streifens (221) von seiner ersten Form in seine zweite Form irreversibel ist.

6. Vorrichtung (200; 400) nach einem der Ansprüche 1 bis 5, wobei in jedem Ventil (218) der mindestens eine Streifen (221) zwei gestapelte Schichten (205, 207) von unterschiedlichen Materialien mit unterschiedlichen thermischen Ausdehnungskoeffizienten aufweist.

7. Vorrichtung (200; 400) nach Anspruch 6, wobei das Material von jeder der Schichten (205, 207) aus Titannitrid, Titan, Aluminium, Kupfer, Eisen, Gold, Wolfram, Platin, einer Eisen-Nickel-Legierung, Siliziumoxid oder einer Legierung aus einem dieser Materialien ausgewählt ist.

8. Vorrichtung (200; 400) nach einem der Ansprüche 1 bis 7, wobei in jedem Ventil (218) der mindestens eine Streifen (221) die Form eines Scheibenteils hat.

9. Vorrichtung (200; 400) nach einem der Ansprüche 1 bis 8, wobei das Mikrorohrnetzwerk weiter erste (213; 413) und zweite (215; 415) Löcher aufweist, welche das zweite Substrat (203) durchqueren und das Netzwerk von zweiten Vertiefungen (211) mit dem Netzwerk von ersten Vertiefungen (209) verbinden.

10. Vorrichtung (200; 400) nach Anspruch 9, wobei die ersten Löcher (213; 313) direkt das Netzwerk von zweiten Vertiefungen (211) mit dem Netzwerk von ersten Vertiefungen (209) verbinden.

11. Vorrichtung (200; 400) nach Anspruch 9 oder 10, wobei jedes zweite Loch 215; 415) direkt das Netzwerk von zweiten Vertiefungen (211) mit dem Netzwerk von ersten Vertiefungen (209) über eines der Ventile (218) verbindet, wobei die Streifen (221) in dem Stapel (205, 207) ausgeformt sind.

12. Vorrichtung (400) nach einem der Ansprüche 9 bis 11, wobei die Löcher (413, 415) eine auseinanderlaufende Form haben.

13. Vorrichtung (200; 400) nach einem der Ansprüche 1 bis 12, wobei die Streifen (221) bistabil sind.

14. Vorrichtung (200; 400) nach einem der Ansprüche 1 bis 12, wobei die Streifen (221) progressiv verformbar sind.

## Claims

1. A device (200; 400) for cooling an integrated circuit chip (IC), comprising a network of micropipes (209, 211, 213, 215; 209, 211, 413, 415) wherein pipe portions are connected by valves (218), each comprising at least one bilayer strip (221).
**Characterized in that** said micropipe network comprises a first network of interconnected trenches (209) located in a first substrate (201), and a second network of interconnected trenches (211) located in a second substrate (203) stacked to the first substrate (201) and separated from the first substrate (201) by a stack of two layers (205, 207) of different materials having different thermal expansion coefficients.

2. The device (200; 400) of claim 1, wherein in each valve (218), said at least one strip (221) is adapted to changing shape under the effect of a variation of its temperature.

3. The device (200; 400) of claim 1 or 2 wherein, in each valve (218), said at least one strip (221) is adapted to passing from a first shape in which the strip (221) delimits in the valve (218) a first opening (219), when its temperature is lower than a first threshold (T1), to a second shape in which the strip (221) delimits in the valve (218) a second opening larger than the first opening, when its temperate reaches the first threshold (T1).

4. The device (200; 400) of claim 3, wherein, in each valve (218), said at least one strip (221) is further adapted to returning from its second shape to its first shape when its temperature falls back below a second threshold (T2) lower than the first threshold (T1).

5. The device (200; 400) of claim 3 wherein, in each valve (218), the passing of said at least one strip (221) from its first shape to its second shape is irreversible.

6. The device (200; 400) of any of claims 1 to 5, wherein, in each valve (218), said at least one strip (221) comprises two stacked layers (205, 207) of different materials having different thermal expansion coefficients.

7. The device (200; 400) of claim 6, wherein the material of each of said layers (205, 207) is selected from among titanium nitride, titanium, aluminum, copper, iron, gold, tungsten, platinum, an iron-nickel alloy, silicon oxide, or an alloy of any of these materials.

8. The device (200; 400) of any of claims 1 to 7, wherein, in each valve (218), said at least one strip (221) has the shape of a disk portion.

9. The device (200; 400) of any of claims 1 to 8, wherein said micropipe network further comprises first (213; 413) and second (215; 415) holes crossing the second substrate (203) and connecting the second trench network (211) to the first trench network (209).

10. The device (200; 400) of claim 9, wherein the first holes (213; 413) directly connect the second trench network (211) to the first trench network (209).

11. The device (200; 400) of claim 9 or 10, wherein each second hole (215; 415) connects the second trench network (211) to the first trench network (209) via one of said valves (218), the strips (221) being formed in said stack (205, 207).

12. The device (400) of any of claims 9 to 11, wherein said holes (413, 415) have a flared shape.

13. The device (200; 400) of any of claims 1 to 12, wherein said strips (221) are bistable.

14. The device (200; 400) of any of claims 1 to 12, wherein said strips (221) are progressively deformable.
